Europäisches Patentamt

European Patent Office

Office européen des brevets

(11) Veröffentlichungsnummer: **0 322 619**
**A1**

## (12) EUROPÄISCHE PATENTANMELDUNG

(21) Anmeldenummer: 88120677.5

(22) Anmeldetag: 10.12.88

(51) Int. Cl.⁴: **B32B 18/00 , H01L 39/12 , H01L 39/24 , C04B 35/00**

(30) Priorität: 24.12.87 DE 3744145

(43) Veröffentlichungstag der Anmeldung:
05.07.89 Patentblatt 89/27

(84) Benannte Vertragsstaaten:
CH DE FR LI SE

(71) Anmelder: **Asea Brown Boveri Aktiengesellschaft**
**Kallstadter Strasse 1**
**D-6800 Mannheim 31(DE)**

(72) Erfinder: **Rohr, Franz Josef, Dr.**
**Forstweg 2**
**D-6941 Absteinach(DE)**
Erfinder: **Reich, Andreas**
**Alstadter Strasse 55**
**D-6900 Heidelberg(DE)**

(74) Vertreter: **Rupprecht, Klaus, Dipl.-Ing. et al**
**c/o BBC Brown Boveri Aktiengesellschaft**
**ZPT Postfach 100351 Kallstadter Strasse 1**
**D-6800 Mannheim 1(DE)**

(54) **Supraleiter und Verfahren zu seiner Herstellung.**

(57) Die Erfindung bezieht sich auf einen Supraleiter (1) aus einem oxidkeramischen Werkstoff, der auf einen Träger (2) aufgetragen ist. Aufgabe der Erfindung ist es, chemische Reaktionen und Wechselwirkungen zwischen dem Material des Träger (2) und dem oxidkeramischen Werkstoff zu verhindern und eine gute Haftung der Schichten mit dem Träger zu gewährleisten. Erfindungsgemäß wird auf den Träger (2) eine Zwischenschicht (3) aus dotiertem Zirkoniumdioxid, reinem Aluminiumoxid, einer Verbindung aus Aluminiumoxid und einem weiteren metallischen Oxid oder einem Mischoxid mit Perowskitstruktur aufgetragen.

## Supraleiter und Verfahren zu seiner Herstellung

Die Erfindung bezieht sich auf einen Supraleiter gemäß dem Oberbegriff des Patentanspruches 1 sowie auf ein Verfahren zur Herstellung desselben.

Supraleiter kommen vor allem in der Energietechnik zur Anwendung. Sie sind für die Weiterentwicklung im Bereich der Kernfusion der supraleitenden Generatoren sowie dem Bau von Starkfeldmagneten erforderlich. Die Supraleiter werden vorzugsweise als Fasern, Bändern, Folien, Rohre, Körper mit Kapillarstruktur oder Körper mit Wabenstruktur bzw. in Form von Platten ausgebildet. Seit längerem werden Supraleiter aus Metallen der D-Metall-Reihe und aus Metallen, die am Anfang der P-Reihe stehen, hergestellt. Seit kurzem ist es auch möglich, Supraleiter aus keramischen Werkstoffen herzustellen. Es handelt sich dabei um oxidkeramische Materialien mit Perowskitstruktur, die supraleitende Eigenschaften aufweisen. Diese oxidkeramischen Werkstoffe werden auf einem metallischen oder nichtmetallischen Träger aufgetragen, der eine definierte mechanische Festigkeit und eine ausreichende Flexibilität aufweist. Bisher wurde bevorzugt Strontiumtitanat (SrTiO₃) für die Herstellung des Trägers verwendet.

Bei der Herstellung dieser Supraleiter müssen die verwendeten Werkstoffe thermischen Behandlungen bei hohen Temperaturen ausgesetzt werden. Es ist deshalb nicht auszuschließen, daß es zwischen dem Werkstoff des Trägers und der supraleitenden Schicht zu chemischen Reaktionen bzw. Wechselwirkungen kommt.

Der Erfindung liegt deshalb die Aufgabe zugrunde, einen Supraleiter zu schaffen, bei dem chemische Reaktionen und Wechselwirkungen zwischen dem Werkstoff des Trägers und dem supraleitenden Material sowohl bei hohen als auch bei tiefen Temperaturen ausgeschlossen werden, sowie ein Verfahren aufzuzeigen, mit dem ein solcher Supraleiter hergestellt werden kann.

Diese Aufgabe wird erfindungsgemäß durch die Merkmale des Patentanspruches 1 gelöst.

Ein Verfahren zur Herstellung eines solchen Supraleiters ist in Patentanspruch 5 offenbart.

Erfindungsgemäß wird für die Ausbildung der Zwischenschicht ein Werkstoff verwendet, der bei der Beschichtung des Trägers und der Nachbehandlung nicht negativ von den dabei herrschenden Bedingungen beeinflusst wird. Insbesondere werden für die Ausbildung der Zwischenschicht solche Werkstoffe verwendet, die thermisch und chemisch wesentlich stabiler sind als das Material des Trägers, bzw. der oxidkeramische Werkstoff der supraleitenden Schicht. Vorzugsweise werden zur Ausbildung der Zwischenschicht Oxide oder Mischoxide auf der Basis von Zirkonium, Aluminium, Magnesium, Cer, Titan, Chrom oder Mischoxide mit Perowskitstruktur verwendet, die bei entsprechender Reinheit oder gezielter Dotierung bis zu Temperaturen von 1500°C thermisch und chemisch stabil sind. Wird zur Ausbildung der Zwischenschicht Zirkoniumdioxid verwendet, so wird dieses vorzugsweise mit Yttriumoxid oder Yttriumoxid und Ytterbiumoxid dotiert. Mit diesen Dotierungsmitteln wird das Kristallgitter des Zirkoniumdioxids stabilisiert. Der Anteil des Dotierungsmittels beträgt 4 bis 8 Mol.%. Die Dotierung von Zirkoniumdioxid ist auch mit Magnesiumoxid möglich. Wird die Zwischenschicht aus Aluminiumoxid gebildet, so wird dieses entweder in reiner Form verwendet, bzw. in Kombination mit Magnesiumoxid, Titanoxid oder Chromoxid. Zur Ausbildung der Zwischenschicht können auch Mischoxide mit Perowskitstruktur in Form von La₁₋ₓ(M)ₓCrO₃ eingesetzt werden. Hierbei steht M stellvertretend für Magnesium, Calcium, Strontium und Barium. Chrom kann dabei teilweise oder ganz durch Eisen, Nickel, Kobalt oder Mangen ersetzt werden. Die Zwischenschicht kann bspw. durch Plasmaspritzen auf den Träger aufgebracht werden. Hierfür wird spritzfähiges Pulver der vorgenannten Materialien, z.B. dotiertes Zirkoniumdioxidpulver hergestellt und in bekannter Weise mit Argon als Trägergas abgeschieden. Die Ausbildung der Zwischenschicht kann auch mit Hilfe einer Suspension erfolgen, wofür ein feinkörniges Pulver, z.B. dotiertes Zirkoniumdioxidpulver hergestellt wird, das mit einem organischen Suspensionsmittel (z.B. Äthanol + Polywachs) gemischt wird. Die Abscheidung aus der Suspension kann durch Tauchen, Sprühen oder Elektrophorese erfolgen. Eine Lösung, z.B.e Salzlösung oder metallorganische Lösungen der Ausgangsstoffe können ebenfalls zur Ausbildung der Zwischenschicht genutzt werden. Ferner kann die Zwischenschicht durch Sputtern aufgetragen werden, wobei entsprechende Targets, z.B. aus dotiertem Zirkoniumdioxid verwendet werden. Ferner ist zur Ausbildung der Zwischenschicht die Abscheidung des für die Herstellung verwendeten Werkstoffes aus der Gasphase möglich. Insbesondere können CVD-Verfahren (Chemical-Vapor-Deposition), PCVD-Verfahren (Plasma-Chemical-Vapor-Deposition) und ECVD-Verfahren (Electrochemical-Vapor-Deposition) Anwendung finden. Mit der Zwischenschicht wird gleichzeitig eine beständige Haftung der supraleitenden Schicht auf dem Träger bewirkt.

Weitere erfindungswesentliche Merkmale sind in den Unteransprüchen gekennzeichnet.

Die Erfindung wird nachfolgend anhand einer Zeichnung näher erläutert.

Die einzige zur Beschreibung gehörende Figur zeigt einen Supraleiter 1, der im wesentlichen durch einen Träger 2, eine Zwischenschicht 3 und die supraleitende Schicht 4 gebildet wird. Der Träger 2 ist als Faser mit zylinderförmigem Querschnitt ausgebildet. Der Träger 2 kann auch als Band oder blattförmig gestaltet werden. Der Träger 2 ist aus einem Metall oder einer Metallegierung oder einem nichtmetallischen Werkstoff, wie z.B. Siliziumcarbid, Siliziumtitanat, Bor, Stahl, Aluminiumoxid oder Glas gefertigt. Um chemische Reaktionen zwischen dem Material des Trägers 2 und der supraleitenden Schicht 4 auszuschließen, ist die Oberfläche 2F des Trägers 2 von einer Zwischenschicht 3 überzogen. Die Dicke der Zwischenschicht 3 beträgt zwischen 1 μm und 100 μm, vorzugsweise 10 bis 30 μm. Sie kann erfindungsgemäß durch ein dotiertes Zirkoniumdioxid gebildet werden. Vorzugsweise wird hierfür Zirkoniumoxid verwendet, das mit Yttriumoxid oder Yttrium- und Ytterbiumoxid dotiert ist, und die nachfolgend dargestellte Strukturformel aufweist:

$(ZrO_2)_{0.92}(Y_2O_3)_{0.8}$

oder

$(ZrO_2)_{0.92}(Y_2O_3)_{0.04}(Yb_2O_3)_{0.04}$

Die Zwischenschicht kann auch durch Aluminiumoxid ($Al_2O_3$) in reiner Form gebildet werden. Eine Kombination von Aluminiumoxid und Magnesiumoxid ist für die Ausbildung der Zwischenschicht ebenfalls möglich. Ebenso kann für die Ausbildung der Zwischenschicht 3 eine Kombination von Aluminiumoxid und Titanoxid ($Al_2O_3/TiO_2$) verwendet werden. Die Kombination von Aluminiumoxid und Chromoxid ($Al_2O_3/Cr_2O_3$) ist ebenfalls möglich. Mischoxide mit Perowskitstruktur können ebenfalls zur Ausbildung der Zwischenschicht verwendet werden. Vorzugsweise eignen sich hierfür $SrTiO_3$, $BaTiO_3$ oder $La_{1-x}^{(M)}{}_x CrO_3$. M steht in der Strukturformel für Magnesium, Calcium, Strontium oder Barium. Mit gewissen Einschränkungen kann anstelle des Chroms hierbei auch Eisen, Nickel, Kobalt oder Mangan verwendet werden.

Zum Auftragen der Zwischenschicht wird ein Pulver aus einem der o.g. Werkstoffe hergestellt. Dieses Pulver wird mittels Plasmaspritzen unter Verwendung von Argon als Trägergas auf die Oberfläche 2F des Träger 2 direkt aufgetragen. Für das Plasmaspritzen eignen sich alle o.g. Werkstoffe. Es besteht ferner die Möglichkeit eine Lösung unter Verwendung von Nitratverbindungen herzustellen. Das Nitrat wird mit Wasser und/oder Alkohol gemischt und eine Lösung mit einer Konzentration von 5 bis 30 Mol.% hergestellt. Diese Lösung kann dann auf die Oberfläche 2F des Trägers aufgesprüht werden. Die Lösung wird in einer solchen Menge aufgetragen, daß nach einer Wärmebehandlung die Zwischenschicht die gewünschte Dicke aufweist. Für die Herstellung der Lösung werden Nitratverbindungen von Zirkonium, Yttrium und Ytterbium verwendet, wenn die Zwischenschicht aus dotierten Zirkoniumdioxid bestehen soll. Nitratverbindungen von Lanthan, Barium und Chrom werden verwendet, wenn die Zwischenschicht durch ein Mischoxid mit Perowskitstruktur gebildet werden soll. Die Oberfläche 2F des Trägers 2 kann ein- oder mehrmals in die Lösung getaucht oder mit dieser besprüht werden. Während einer Wärmebehandlung bei einer Temperatur zwischen 850 °C und 950 °C wird das Lösungsmittel verdampft und das Nitrat thermisch oxidativ zersetzt, so daß es unter der Einwirkung von Sauerstoff zur Ausbildung der gewünschten Zwischenschicht. Erfindungsgemäß kann zur Ausbildung der Zwischenschicht 3 auch eine Suspension verwendet werden. Die Suspension wird aus sehr feinkörnigem Pulver des Zwischenschichtmaterials aus Alkoholat- oder Oxalat-Verbindungen der Ausgangsstoffe oder einem Mischoxid mit Perowskitstruktur hergestellt. Hierfür eignen sich besonders solche Alkoholate oder Oxalate die Zirkonium und Yttrium bzw. Aluminium und Magnesium als Metallkomponenten aufweisen. Zur Ausbildung der Suspension werden vorzugsweise 50 Gew.% Äthanol und 2 Gew.% Polyglykol mit dem feinkörnigen Pulver gemischt. Die Oberfläche 2F des Trägers 2 kann durch Tauchen in die Suspension mit der Zwischenschicht 3 versehen werden. Es besteht selbstverständlich auch die Möglichkeit, die Zwischenschicht durch Sprühen oder Aufstreichen der Suspension auf die Oberfläche 2F auszubilden. Die Zwischenschicht kann auch durch Elektrophorese aus der Suspension abgeschieden werden. Die Menge der aufgetragenen Suspension wird so gewählt, daß die Zwischenschicht 3 nach der Fertigstellung die gewünschte Dicke aufweist. Nach dem Auftragen der Suspension wird der Träger einer Wärmebehandlung bei einer Temperatur von 800 bis 950 °C ausgesetzt, wobei eine dauerhafte Verbindung der Zwischenschicht 3 mit dem Träger 2 erreicht und das Suspensionsmittel verdampft wird.

Durch Sputtern unter Verwendung eines Targets aus einem der beschriebenen Werkstoffe ist die Ausbildung der Zwischenschicht 3 ebenfalls möglich.

Durch Abscheidung von dotiertem Zirkoniumoxid, reinem Aluminiumoxid oder einer Kombination aus Aluminium- und Magnesiumoxid bzw. Aluminium- und Titanoxid oder Aluminiumoxid und Chromoxid bzw. einem Mischoxid mit Perowskitstruktur, wie es oben beschrieben ist, aus der Gasphase läßt sich die Zwischenschicht ebenfalls ausbilden. Insbesondere können hierbei CVD-Verfahren, PCVD-Verfahren und ECVD-Verfahren angewendet werden. Zur Verbesserung der Haftung und Kompatibilität von keramischen Zwischenschichten 3 mit einem Träger 2, der aus einem Metall oder einer Legierung hergestellt ist, kann eine Haftvermittlerschicht (hier nicht dargestellt) aus MCrAlY (M = Ni,Co,Fe) unmittelbar auf den Träger 2 durch Plasmaspritzen aufgebracht werden. Nachdem die Zwischenschicht auf die Oberfläche 2F des Trägers 2 aufgetragen ist, wird darauf die supraleitenden Schicht 4 abgeschieden. Bei Zwischenschichten 3 aus Zirkoniumoxid kann zur Einstellung einer optimalen Sauerstoffstöchiometrie in der supraleitenden Schicht 4 der Sauerstofftransport durch die Zirkoniumoxidschicht genutzt. Hierfür wird nach dem Auftragen der supraleitenden Schicht 4 eine Gleichspannung zwischen dem elektrisch leitenden gasdurchlässigen Träger 2 und der supraleitenden Schicht 4 angelegt, wodurch die Permeation des Sauerstoffs durch die Zirkonoxidschicht wesentlich verstärkt wird.

Die supraleitende Schicht selbst wird einer zusätzlichen Nachbehandlung mit Sauerstoff unterzogen, wobei der gesamte Supraleiter 1 an Luft auf 850 °C bis 950 °C erhitzt und anschließend langsam in Sauerstoffatmosphäre abgekühlt und bei 400 bis 500 °C ca. 4 bis 16 h getempert wird.

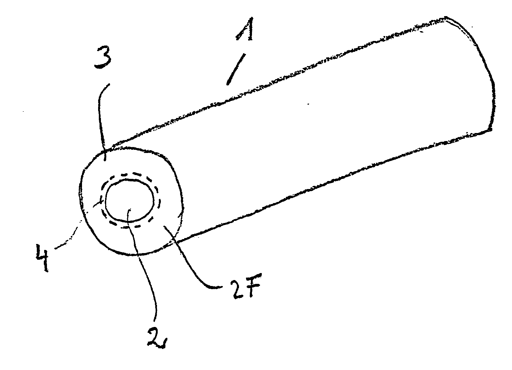

**Ansprüche**

1. Supraleiter aus einem oxidkeramischen Werkstoff, der auf einen Träger (2) aufgetragen ist, dadurch gekennzeichnet, daß unmittelbar auf die zu beschichtende Oberfläche (2F) des Trägers (2) wenigstens eine Zwischenschicht (3) aufgetragen ist.

2. Supraleiter nach Anspruch 1, dadurch gekennzeichnet, daß die Zwischenschicht aus einem dotierten Zirkoniumdioxid, einem dotierten Ceroxid, einem reinen Aluminiumoxid, einer Kombination aus Magnesiumoxid und Aluminiumoxid, einer Kombination aus Aluminiumoxid und Titanoxid, einer Kombination aus Aluminiumoxid und Chromoxid oder einem Mischoxid mit Perowskitstruktur gebildet ist.

3. Supraleiter nach Anspruch 1, dadurch gekennzeichnet, daß das Zirkoniumdioxid mit Yttrium und/oder Ytterbium dotiert ist und die Strukturformel

$$(ZrO_2)_{1-x}(Y_2O_3)_x$$

oder

$$(ZrO_2)_{1-y-z}(Y_2O_3)_y(Yb_2O_3)_z$$

aufweis und x bzw. y + z folgende Werte annehmen 0,04 ≤ x ≤ 0,1 bzw. 0,04 ≤ y + z ≤ 0,1, daß das dotierte Zirkoniumdioxid die bevorzugten Zusammensetzungen aufweist:

$$(ZrO_2)_{0.92}(Y_2O_3)_{0.8}$$
oder
$$(ZrO_2)_{0.92}(Y_2O_3)_{0.04}(Yb_2O_3)_{0.04}$$

4. Supraleiter nach einem der Ansprüche 1 oder 2, dadurch gekennzeichnet, daß die Zwischenschicht (3) aus Strontiumtitanat ($SrTiO_3$), Bariumtitanat ($BaTiO_3$) oder $La_{1-x}^{(M)}{}_x CrO_3$ gebildet ist, wobei M stellvertretend für Magnesium, Calcium, Strontium oder Barium steht und Chrom ganz oder teilweise durch Eisen, Nickel, Kobalt oder Mangan ersetzbar ist.

5. Verfahren zur Herstellung eines Supraleiters (1) mit einer supraleitenden Schicht (4), aus einem oxidkeramischen Werkstoff, der auf einen Träger aufgetragen ist, insbesondere nach Anspruch 1, dadurch gekennzeichnet, daß die Zwischenschicht (3) durch Plasmaspritzen, aus einer Lösung, aus einer Suspension, durch Sputtern oder aus der Gasphase auf die Oberfläche (2F) des Trägers (2) aufgetragen wird.

6. Verfahren nach Anspruch 5, dadurch gekennzeichnet, daß zur Ausbildung der Zwischenschicht (3) aus dem zu verwendenden Werkstoff ein feinkörniges Pulver hergestellt wird, das mittels Plasmaspritzen unter Verwendung von Argon als Trägergas auf die Oberfläche (2F) des Trägers (2) aufgetragen wird.

7. Verfahren nach Anspruch 5, dadurch gekennzeichnet, daß zur Ausbildung der Zwischenschicht (3) aus Nitratverbindungen von Zirkonium, Yttrium und Ytterbium unter Beimischen von Wasser und Alkohol, z.B. von Isopropylalkohol, eine Lösung gebildet wird, deren Konzentration 5 bis 30 Mol.% beträgt, und daß diese Lösung auf die Oberfläche (2F) des Trägers (2) aufgetragen und die Nitratverbindungen bei einer Temperatur von 850 °C bis 950 °C thermisch oxidativ zersetzt werden.

8. Verfahren nach Anspruch 5, dadurch gekennzeichnet, daß zur Ausbildung der Zwischenschicht (3) aus Nitratverbindungen von Aluminium bzw. Aluminium und Titan bzw. Aluminium und Chrom bzw. Strontium und Titan bzw. Barium und Titan bzw. Lanthan, Strontium und Chrom bzw. Lanthan, Magnesium und Chrom bzw. Lanthan, Barium und Chrom bzw. Lanthan, Strontium und Chrom mit Wasser und Alkohol, z.B. Isopropylakohol eine Lösung gebildet wird, deren Konzentration 5 bis 30 Mol.% beträgt, daß die Lösung auf die Oberfläche (2F) des Trägers (2) aufgetragen und die Nitratverbindungen in einer Sauerstoffatmosphäre bei 850 °C bis 950 °C thermisch oxidativ zersetzt werden.

9. Verfahren nach Anspruch 5, dadurch gekennzeichnet, daß zur Bildung der Zwischenschicht (3) aus feinkörnigem Pulver der Mischoxide des Zirkoniums und Yttriums bzw. des Zirkoniums und/oder Yttriums und Ytterbiums und 50 Gew.% Äthanol sowie 2 Gew.% Polyglycol eine Suspension gebildet wird, die durch Tauchen, Sprühen oder Bestreichen der zu beschichtenden Oberfläche (2F) des Trägers (2) oder durch Elektrophorese aufgebracht und durch Sintern bei 950 °C dauerhaft mit dem Träger (2) verbunden wird.

10. Verfahren nach Anspruch 5, dadurch gekennzeichnet, daß zur Bildung der Zwischenschicht (3) aus Aluminiumoxid, einer Verbindung aus Magnesium- und Aluminiumoxid, einer Verbindung aus Aluminiumoxid und Titanoxid einer Aluminium-Chromoxidverbindung oder einem Mischoxid mit Perowskitstruktur sowie 50 Gew.% Äthanol und 2 Gew.% Polyglycol eine Suspension gebildet wird, die durch Tauchen, Sprühen oder Bestreichen der zu beschichtenden Oberfläche (2F) des Trägers (2) oder durch Elektrophorese aufgetragen und durch Sintern bei 950 °C dauerhaft mit dem Träger (2) verbunden wird.

11. Verfahren nach Anspruch 10, dadurch gekennzeichnet, daß zur Ausbildung der Zwischenschicht (3) als Mischoxid mit Perowskitstruktur $SrTiO_3$, $BaTiO_3$ oder $La_{1-x}(M)_xCrO_3$ verwendet wird, wobei M stellvertretend für Magnesium, Calcium, Strontium und Barium steht, und der Chromanteil ganz oder teilweise durch Eisen, Nickel, Kobalt oder Mangan ersetzt werden kann.

12. Verfahren nach Anspruch 5, dadurch gekennzeichnet, daß zur Bildung der Zwischenschicht (3) dotiertes Zirkoniumoxid, reines Aluminiumoxid, eine Verbindung aus Aluminiumoxid und Magnesiumoxid, eine Verbindung aus Aluminiumoxid und Titanoxid, eine Verbindung aus Aluminiumoxid und Chromoxid oder ein Mischoxid mit Perowskitstruktur aus der Gasphase auf die zu beschichtende Oberfläche (2F) des Trägers (2) unter Anwendung eines CVD-Verfahren, eines PCVD-Verfahrens oder eines ECVD-Verfahrens abgeschieden wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | ADVANCED CERAMIC MATERIALS, Band 2, Nr. 3B, Juli 1987, Seiten 401-410, "Special Issue", American Ceramic Society; J.P. KIRKLAND et al.: "Thermal spraying superconducting oxide coatings" * Seite 402, Zeilen 1-33 * --- | 1,2,5 | B 32 B 18/00 H 01 L 39/12 H 01 L 39/24 C 04 B 35/00 |
| X | ADVANCED CERAMIC MATERIALS, Band 2, Nr. 3B, Juli 1987, Seiten 411-421, "Special Issue", American Ceramic Society; W.T. ELAM et al.: "Plasma sprayed high Tc superconductors" * Seite 412, Zeile 20 - Seite 413, Zeile 3 * --- | 1,2,5,6 ,10,12 | |
| A | IDEM --- | 3,4,7-9 ,11 | |
| A | DE-A-2 852 647 (ROBERT BOSCH GmbH) * Ansprüche 1-8 * ----- | 1-12 | |
|  |  |  | **RECHERCHIERTE SACHGEBIETE (Int. Cl.4)** |
|  |  |  | B 32 B H 01 L C 04 B |

Der vorliegende Recherchenbericht wurde für alle Patentansprüche erstellt

| Recherchenort | Abschlußdatum der Recherche | Prüfer |
|---|---|---|
| DEN HAAG | 31-03-1989 | LUETHE H. |